# EUROPEAN PATENT SPECIFICATION

(11) **EP 3 281 210 B1**
(45) Date of publication and mention of the grant of the patent: **17.06.2020**
(21) Application number: 16718575.0
(22) Date of filing: 07.04.2016
(51) Int. Cl.: H01B 1/20, H01B 3/30, H01B 11/10, H01B 11/18, H01P 3/06

(54) **CABLE SHIELDING ASSEMBLY AND PROCESS OF PRODUCING CABLE SHIELDING ASSEMBLY**
KABELABSCHIRMUNGSANORDNUNG UND VERFAHREN ZUR HERSTELLUNG DER KABELABSCHIRMUNGSANORDNUNG
ENSEMBLE DE BLINDAGE DE CÂBLE ET PROCÉDÉ DE PRODUCTION D'UN ENSEMBLE DE BLINDAGE DE CÂBLE

(30) Priority: 10.04.2015 US 201514684276
(43) Date of publication of application: 14.02.2018
(73) Proprietor: TE Connectivity Corporation, Berwyn, PA 19312 (US)
(72) Inventor: WANG, Jialing, Mountain View, CA 94043 (US); LLOYD, Richard, B., Sunnyvale, CA 94089 (US); GAO, Ting, Palo Alto, CA 94306 (US); DAS, Jaydip, Cupertino, CA 95014 (US)
(74) Representative: Johnstone, Douglas Ian
(86) International application number: PCT/US2016/026508
(87) International publication number: WO 2016/164627

(56) References cited:
- EP-A2- 0 452 942
- JP-A- 2010 165 637

## Description

### FIELD OF THE INVENTION

The present invention is directed to cable shielding assemblies and processes of producing such assemblies. More particularly, the present invention is directed to cable shielding assemblies with conductive composite shields.

### BACKGROUND OF THE INVENTION

In general, cable shielding materials can be metallic or include ferrites. Metallic shields come in the form of braids, tapes, tubular, spiral, knitted wire mesh with a plastic cover, laminates, plated yarns and fabrics, and many more arrangements. Such shields provide shielding effect for low frequency applications, but they have several drawbacks. For example, braids have diminishing shielding effectiveness in high frequency ranges due to poor optical coverage. Metallic shields can be heavy and/or require costly and complex plating processes, as well as, braiding and/or tape-wrapping processes. Ferrite beads are used for high frequency noise suppression, but they can be limited by the frequency range that the specific type of ferrite allows and are not suitable for high frequency signal devices. EP0452942 discloses an electromagnetically shielded cable comprising a conductor surrounded by an inner insulation layer and an outer electrically conductive shield. The electrically conductive shield comprises conductive particles within a thermoplastic resin.

A cable shielding assembly and process of producing a cable shielding assembly that show one or more improvements in comparison to the prior art would be desirable in the art.

### BRIEF DESCRIPTION OF THE INVENTION

In an embodiment, a cable shielding assembly includes a conductor and a conductive composite shield extending around at least a portion of the conductor, the conductive composite shield having a non-conductive matrix and conductive particles within the non-conductive matrix. The conductive composite shield has a resistivity of less than 0.05 ohm·cm. The conductive particles of the conductive composite shield have a volume concentration within the non-conductive matrix between 20% and 40% total loading.

In another embodiment, a cable shielding assembly includes a conductor, a dielectric material extending around at least a portion of the conductor, a conductive composite shield extending around at least a portion of the conductor and at least a portion of the dielectric material, the conductive composite shield having a non-conductive matrix and conductive particles within the non-conductive matrix, and a jacket material extending around at least a portion of the conductive composite shield. The conductive composite shield has a resistivity of less than 0.05 ohm·cm. The conductive particles of the conductive composite shield have a volume concentration within the non-conductive matrix between 20% and 40% total loading.

In another embodiment, a process of producing a cable shielding assembly includes positioning a conductive composite shield, the conductive composite shield having a non-conductive matrix and conductive particles within the non-conductive matrix. The positioning is at least partially around a conductor, at least partially around a dielectric material, at least partially surrounded by a jacket material, or a combination thereof. The conductive composite shield has a resistivity of less than 0.05 ohm·cm. The conductive particles of the conductive composite shield have a volume concentration within the non-conductive matrix between 20% and 40% total loading.

Other features and advantages of the present invention will be apparent from the following more detailed description, taken in conjunction with the accompanying drawings which illustrate, by way of example, the principles of the invention.

### BRIEF DESCRIPTION OF THE DRAWINGS

FIG. 1 is a schematic view of an embodiment of a cable shielding assembly, according to the disclosure.
FIG. 2 is a graphical representation of shielding effectiveness in dB shown on the y-axis from 10 MHz to 67 GHz and frequency in GHz shown on the x-axis of an embodiment of a cable shielding assembly in comparison to shielding provided from braids and metal tape, according to the disclosure.
FIG. 3 is a graphical representation of shielding effectiveness in dB shown on the y-axis from 10 MHZ to 10 GHz and frequency in GHz shown on the x-axis of the embodiment of a cable shielding assembly as shown in FIG. 2, in comparison to shielding provided from braids and metal tape, according to the disclosure.
FIG. 4 is a graphical representation of tensile strength on the y-axis in MPa versus elongation of polymer bases of non-conductive matrices for cable shielding assemblies on the x-axis in percent, according to embodiments of the disclosure.

Wherever possible, the same reference numbers will be used throughout the drawings to represent the same parts.

### DETAILED DESCRIPTION OF THE INVENTION

Provided are a cable shielding assembly and process of producing the cable shielding assembly. Embodiments of the present disclosure, for example, in comparison to concepts failing to include one or more of the features disclosed herein, permit increases in shielding of electronic components, permit increased shielding effectiveness in higher frequency ranges, permit flexibility, permit decreased fabrication costs, permit reduction of weight of articles including such shields instead of alternative shielding mechanisms, permit heat-recoverable materials to be secured without an adhesive adversely increasing resistivity, provide shielding from electromagnetic interference, permit termination and grounding without the use of metal braids, permit other suitable advantages and distinctions, and permit combinations thereof.

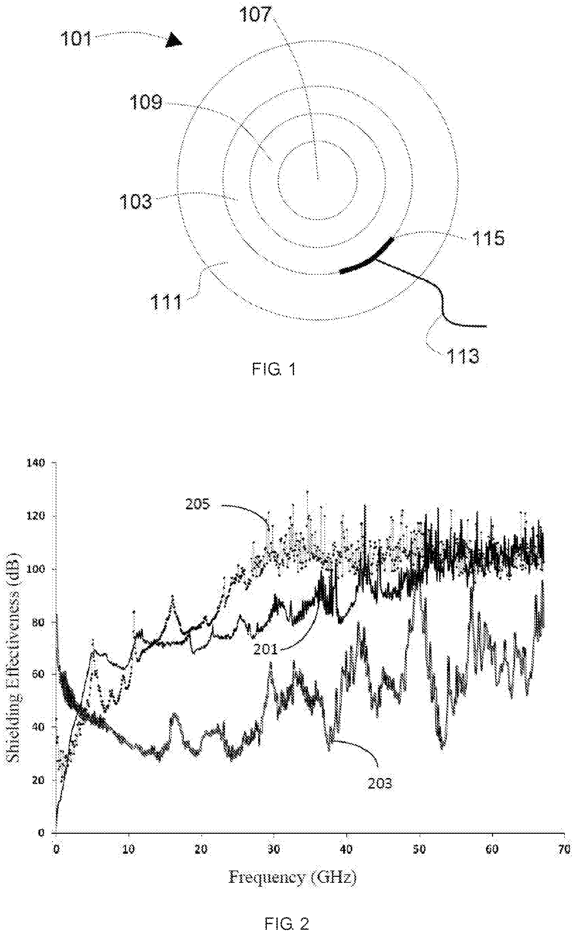

FIG. 1 shows a cable shielding assembly 101 including a conductor 107 and a conductive composite shield 103 extending around at least a portion of the conductor 107. The conductive composite shield 103 has a non-conductive matrix and conductive particles within the non-conductive matrix, for example, being an extrudable thermoplastic blend having a density range (for example, between 3 g/cc and 5 g/cc), a resistivity range (for example, less than 0.05 ohm·cm, less than 0.03 ohm·cm, less than 0.025 ohm·cm, or lower), and/or a contact resistance range (for example, 500 milliohm or lower). As used herein, the term "resistivity" refers to measurable values determined upon extrusion and/or full recovery and does not refer to values measured while in an expanded state. In one embodiment, the cable shielding assembly 101 forms a portion or entirety of an article, such as, a wire, a cable, or a combination thereof. As used herein, the term "shielding" is intended to reference an independent structure or portion of an independent structure. It is not intended to encompass coatings or such layers positioned on another structure. Suitable resistivity values of the conductive composite shield 103 include are less than 0.025 ohm·cm, for example, between 0.025 ohm·cm and 0.008 ohm·cm.

The thickness of the conductive composite shield 103 is between 0.4 mm and 2 mm, 0.4 mm and 1.6 mm, 0.5 mm, 1 mm, 1.5 mm, between 0.07 mm and 0.5 mm, between 0.1 mm and 0.5 mm, between 0.2 mm and 0.5 mm, greater than 0.1 mm, greater than 0.2 mm, greater than 0.4 mm, or any suitable combination, sub-combination, range, or sub-range therein.

In one embodiment, the cable shielding assembly 101 includes a dielectric material 109 being at least partially surrounded by the conductive composite shield 103, a jacket material 111 at least partially surrounding the conductive composite shield 103, or a combination thereof. In a further embodiment, the dielectric material 109 is devoid or substantially devoid of the conductive particles and includes the same polymer matrix material as the conductive composite shield 103 or another suitable species of the polymer matrix materials.

The cable shielding assembly 101 is capable of including other suitable features for termination and/or grounding. For example, in one embodiment, the direct solderability of the conductive composite shield 103 in the cable shielding assembly 101 permits the cable shielding assembly 101 to include one or more drain wires 113 or metal straps connected to the conductive composite shield 103. For example, in one embodiment, the drain wire(s) 113 or metal straps is/are electrically terminated/connected to the conductive composite shield 103 by solder 115 and are embedded within. Additionally or alternatively, termination and grounding of the cable shielding assembly 101 is capable of being achieved by a crimp coaxial connector.

In one embodiment, the material of the non-conductive matrix is selected based upon tensile strength and/or elongation at break (for example, based upon ASTM D638, Standard Test Method for Tensile Properties of Plastics). A polymer base of the non-conductive matrix impacts the tensile strength at break and elongation at break.

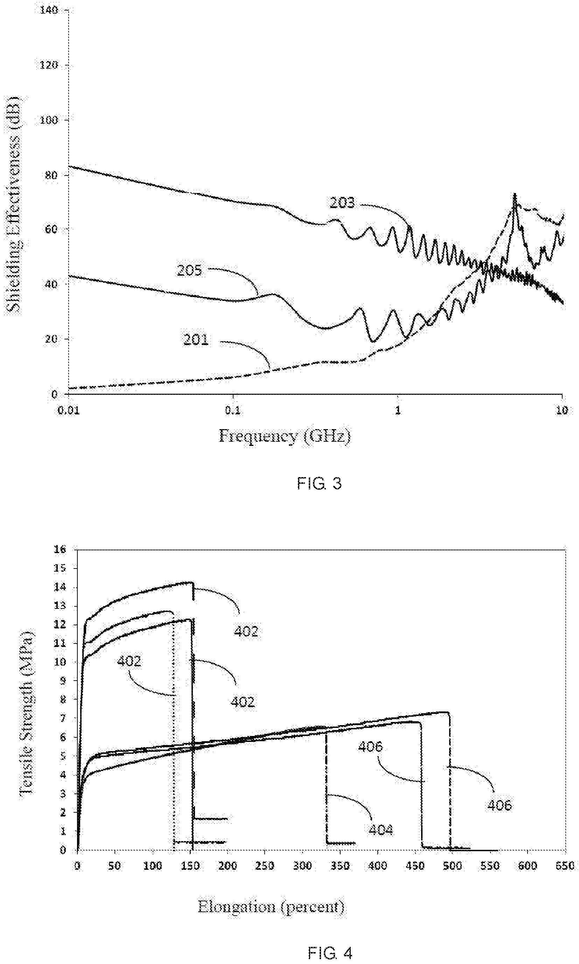

For example, in one embodiment, the PVDF is in the non-conductive matrix as a polymer base, and the tensile strength at break of the non-conductive matrix is between 10 MPa and 20 MPa (for example, between 12 MPa and 15 MPa as shown in PVDF plots 402 of FIG. 4 and/or the elongation at break is between 100% and 200% (for example, between 130% and 160% as shown in FIG. 4).

In one embodiment, tetrafluoroethylene, hexafluoropropylene and vinylidene fluoride (THV) is in the non-conductive matrix as a polymer base, and the tensile strength at break of the non-conductive matrix is between 4 MPa and 8 MPa (for example, between 6 MPa and 7 MPa as shown in THV plots 404 of FIG. 4) and/or the tensile elongation at break is between 300% and 400% (for example, between 320% and 350% as shown in FIG. 4).

In one embodiment, metallocene-catalyzed polyethylene (m-LLDPE) is in the non-conductive matrix as a polymer base, and the tensile strength at break of the non-conductive matrix is between 4 MPa and 10 MPa (for example, between 6 MPa and 8 MPa as shown in m-LLDPE plots 406 of FIG. 4) and/or the tensile elongation at break is between 400% and 600% (for example, between 450% and 500% as shown in FIG. 4).

Suitable non-conductive matrices include, but are not limited to, the PVDF, copolymers of vinylidene fluoride (VDF) and hexafluoropropylene (HFP), terpolymers of VDF, HFP and tetrafluoroethylene (TFE), fluorinated ethylene propylene, ethylene tetrafluoroethylene, polytetrafluoroethylene, other suitable fluorinated matrices compatible with the conductive particles, or a combination thereof. Other suitable non-conductive matrices include, but are not limited to the polyethylene, polypropylene, ethylene-vinyl acetate, polyamide, neoprene, or a combination thereof.

In one embodiment, the non-conductive matrix has a crystallinity within a specific range, for example, between 15% and 65%, between 15% and 35%, between 15% and 20%, between 18% and 19%, between 30% and 35%, between 32% and 34%, or any suitable combination, sub-combination, range, or sub-range therein.

The conductive particles are or include copper particles, tin particles, nickel particles, aluminum particles, carbon particles, carbon black, carbon nanotubes, graphene, silver-coated particles, nickel-coated particles, other suitable conductive particles compatible with the non-conductive matrix, or a combination thereof. Suitable morphologies for the conductive particles include, but are not limited to, dendrites, flakes, fibers, and spheres. In one embodiment, the conductive particles are or include copper dendrites having average sizes of between 20 micrometers and 30 micrometers, at a relative volume concentration of between 40% and 70% (for example, 60%), and tin spheres having average sizes of between 8 micrometers and 16 micrometers, at a relative volume concentration of between 30% and 50% (for example, 40%).

In one embodiment, the concentration of the conductive particles within the non-conductive matrix is above the percolation threshold, which is lower for semicrystalline polymers than amorphous polymers due to the semicrystalline polymers including more efficient filler network formation around polymer crystallites. Additionally or alternatively, in one embodiment, the concentration of the conductive particles within the non-conductive matrix is below a recrystallization-limiting threshold. As used herein, the phrase "recrystallization-limiting threshold" refers to a concentration of the conductive particles within in the non-conductive matrix at which the cooling after melt-mixing would not permit a substantially equivalent reformation of crystals in the non-conductive matrix.

According to the invention suitable volume concentrations of the conductive particles within the non-conductive matrix include between 20% and 40% total loading, preferably between 20% and 35% total loading, between 25% and 40% total loading, between 25% and 35% total loading, between 28% and 32% total loading, between 29% and 31% total loading, or any suitable combination, sub-combination, range, or sub-range therein.

In addition to the non-conductive matrix and the conductive particles, the conductive composite shield 103 includes any other suitable constituents. For example, in one embodiment, the conductive composite shield 103 includes a sebacate-type of plasticizer. Suitable concentrations of the sebacate-type plasticizer include, but are not limited to, a volume concentration of between 5% and 10% (for example, 7.5%). In one embodiment, the composite shield 103 includes a process aid for facilitating filler dispersion and increasing processability in a homogenous or substantially homogenous manner. Additionally or alternatively, in other embodiments, the conductive composite shield 103 includes or is devoid of a crosslinking agent or crosslinking agents, antioxidant(s), flame retardant(s), coupling agent(s), or other additives.

The conductor 107, the conductive composite shield 103, the dielectric material 109, the jacket material 111, the drain wire(s) 113, the solder 115, and/or any other portion of the cable shielding assembly 101 is capable of being produced and/or applied by co-extrusion, tandem-extrusion, add-on processes, or a combination thereof.

Referring to FIGS. 2 and 3, in one embodiment, shielding effectiveness of the conductive composite shield 103 (see 201) exceeds shielding effectiveness of double shields of braids and metal tape (see 203) within a frequency range of at least throughout, 5 GHz to 67 GHz, 5 GHz to 30 GHz, 40 GHz to 67 Hz, or any suitable combination, sub-combination, range, or sub-range therein as shown in FIGS. 2 and 3. In a further embodiment, shielding effectiveness of the conductive composite shield 103 (see 201) overlaps shielding effectiveness of the double shields of the braids and the metal tape when used with the conductive composite (see 205) within a frequency range of at least throughout 5 GHz to 7 GHz, 5 GHz to 12 GHz, 42 GHz to 67 GHz, or any suitable combination, sub-combination, range, or sub-range therein as shown in FIGS. 2 and 3. Specifically, the double shields of the braids and the metal tape compared to herein are silver-plated copper braids with silver-plated copper tape, for example, as used in the production of coaxial cable and having dimensions of 3.58 millimeter thickness and 3.25 millimeter thickness, respectively.

Unlike a homogeneous metal shield, the DC resistivity of the conductive composite shield does not completely predict the shielding effectiveness of the material. These conductive composite materials typically have much greater shielding effectiveness than would be expected, especially at frequencies greater than 1 GHz. Thus, a resistivity as high as 0.05 ohm-cm compared to metals in the 1x10⁻⁶ ohm cm range, can still give adequate shielding performance. In addition, using the conductive composite shield plus a metal braided or wrapped shield is synergistic. The metal shield has good low frequency shielding (i.e. in the KHz to 1 GHz range), but shielding effectives decreases at higher frequencies. The conductive composite shields described herein tend to have the opposite behavior. In addition, combining a metal braid with a conductive composite shield allows the use of conventional connectors and termination methods.

While the invention has been described with reference to one or more embodiments, it will be understood by those skilled in the art that various changes may be made without departing from the scope of the invention as defined by the appended claims. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified.

## Claims

1. A cable shielding assembly (101), comprising:
a conductor (107); and
a conductive composite shield (103) extending around at least a portion of the conductor, the conductive composite shield having a non-conductive matrix and conductive particles within the non-conductive matrix;
wherein the conductive composite shield has a resistivity of less than 0.05 ohm·cm;
**characterised in that**:
the conductive particles of the conductive composite shield have a volume concentration within the non-conductive matrix between 20% and 40% total loading.

2. The cable shielding assembly (101) of claim 1, further comprising a dielectric material (109) extending around at least a portion of the conductor (107), wherein the conductive composite shield (103) extends around at least a portion of the dielectric material.

3. The cable shielding assembly (101) of claim 1, further comprising a jacket material (111) extending around at least a portion of the conductive composite shield (103).

4. The cable shielding assembly (101) of claim 3, wherein the jacket material (111) and the conductive composite shield (103) are at least partially co-extruded.

5. The cable shielding assembly (101) of claim 3, further comprising a drain wire embedded and electrically terminated between the conductive composite shield (103) and the jacket material (111) and extending from the cable shielding assembly.

6. The cable shielding assembly (101) of claim 1, wherein the conductive composite shield has a resistivity of between 0.008 ohm·cm and 0.025 ohm·cm.

7. The cable shielding assembly (101) of claim 1, wherein the conductive composite shield (103) has a thickness of between 0.4 mm and 2 mm, preferably wherein the conductive composite shield has a thickness of between 0.1 mm and 0.46 mm.

8. The cable shielding assembly (101) of claim 1, wherein the non-conductive matrix includes material selected from the group consisting of polyvinylidene fluoride (PVDF), copolymers of vinylidene fluoride (VDF) and hexafluoropropylene (HFP), terpolymers of VDF, HFP and tetrafluoroethylene (TFE), fluorinated ethylene propylene, ethylene tetrafluoroethylene, polytetrafluoroethylene, a fluorinated matrix compatible with the conductive particles, polyethylene, polypropylene, ethylene-vinyl acetate, polyamide, neoprene, and combinations thereof.

9. The cable shielding assembly (101) of claim 1, wherein the conductive particles include particles selected from the group consisting of copper particles, tin particles, nickel particles, aluminum particles, carbon particles, carbon black, carbon nanotubes, graphene, silver-coated particles, nickel-coated particles, or a combination thereof.

10. A process of producing a cable shielding assembly (101), the process comprising:
positioning a conductive composite shield (103), the conductive composite shield having a non-conductive matrix and conductive particles within the non-conductive matrix;
wherein the positioning is at least partially around a conductor (107), at least partially around a dielectric material (109), at least partially surrounded by a jacket material (111), or a combination thereof;
wherein the conductive composite shield (103) has a resistivity of less than 0.05 ohm·cm;
**characterised in that**:
the conductive particles of the conductive composite shield have a volume concentration within the non-conductive matrix between 20% and 40% total loading.

## Patentansprüche

1. Kabelabschirmungsanordnung (101), die Folgendes umfasst:
einen Leiter (107); und
eine leitfähige Verbundstoffabschirmung (103), die um wenigstens einen Teil des Leiters herum verläuft, wobei die leitende Verbundstoffabschirmung eine nicht leitfähige Matrix und leitfähige Partikel in der nicht leitfähigen Matrix hat;
wobei die leitfähige Verbundstoffabschirmung einen spezifischen Widerstand von weniger als 0,05 Ohm·cm hat;
**dadurch gekennzeichnet, dass**:
die leitfähigen Partikel der leitfähigen Verbundstoffabschirmung eine Volumenkonzentration innerhalb der nicht leitfähigen Matrix zwischen 20 % und 40 % Gesamtbelastung haben.

2. Kabelabschirmungsanordnung (101) nach Anspruch 1, die ferner ein dielektrisches Material (109) umfasst, das um wenigstens einen Teil des Leiters (107) herum verläuft, wobei die leitfähige Verbundstoffabschirmung (103) um wenigstens einen Teil des dielektrischen Materials herum verläuft.

3. Kabelabschirmungsanordnung (101) nach Anspruch 1, die ferner ein Mantelmaterial (111) umfasst, das um wenigstens einen Teil der leitfähigen Verbundstoffabschirmung (103) herum verläuft.

4. Kabelabschirmungsanordnung (101) nach Anspruch 3, wobei das Mantelmaterial (111) und die leitfähige Verbundstoffabschirmung (103) wenigstens teilweise koextrudiert sind.

5. Kabelabschirmungsanordnung (101) nach Anspruch 3, die ferner einen Drain-Draht umfasst, der zwischen der leitfähigen Verbundstoffabschirmung (103) und dem Mantelmaterial (111) eingebettet und elektrisch dazwischen terminiert ist und sich von der Kabelabschirmungsanordnung erstreckt.

6. Kabelabschirmungsanordnung (101) nach Anspruch 1, wobei die leitfähige Verbundstoffabschirmung einen spezifischen Widerstand zwischen 0,008 Ohm·cm und 0,025 Ohm·cm hat.

7. Kabelabschirmungsanordnung (101) nach Anspruch 1, wobei die leitfähige Verbundstoffabschirmung (103) eine Dicke zwischen 0,4 mm und 2 mm hat, wobei die leitfähige Verbundstoffabschirmung vorzugsweise eine Dicke zwischen 0,1 mm und 0,46 mm hat.

8. Kabelabschirmungsanordnung (101) nach Anspruch 1, wobei die nicht leitfähige Matrix ein Material beinhaltet, das ausgewählt ist aus der Gruppe bestehend aus Polyvinylidenfluorid (PVDF), Copolymeren aus Vinylidenfluorid (VDF) und Hexafluorpropylen (HFP), Terpolymeren aus VDF, HFP und Tetrafluorethylen (TFE), fluoriniertem Ethylenpropylen, Ethylentetrafluorethylen, Polytetrafluorethylen, einer fluorinierten Matrix, die mit den leitfähigen Partikeln kompatibel ist, Polyethylen, Polypropylen, Ethylen-Vinylacetat, Polyamid, Neopren und Kombinationen davon.

9. Kabelabschirmungsanordnung (101) nach Anspruch 1, wobei die leitfähigen Partikel Partikel beinhalten, die ausgewählt sind aus der Gruppe bestehend aus Kupferpartikeln, Zinnpartikeln, Nickelpartikeln, Aluminiumpartikeln, Kohlenstoffpartikeln, Ruß, Kohlenstoffnanoröhrchen, Graphen, silberbeschichteten Partikeln, nickelbeschichteten Partikeln oder einer Kombination davon.

10. Verfahren zur Herstellung einer Kabelabschirmungsanordnung (101), wobei das Verfahren Folgendes beinhaltet:
Positionieren einer leitfähigen Verbundstoffabschirmung (103), wobei die leitfähige Verbundstoffabschirmung eine nicht leitfähige Matrix und leitfähige Partikel in der nicht leitfähigen Matrix hat;
wobei das Positionieren wenigstens teilweise um einen Leiter (107), wenigstens teilweise um ein dielektrisches Material (109), wenigstens teilweise von einem Mantelmaterial (111) umgeben oder eine Kombination davon ist;
wobei die leitfähige Verbundstoffabschirmung (103) einen spezifischen Widerstand von weniger als 0,05 Ohm·cm hat;
**dadurch gekennzeichnet, dass**:
die leitfähigen Partikel der leitfähigen Verbundstoffabschirmung eine Volumenkonzentration in der nicht leitfähigen Matrix zwischen 20 % und 40 % Gesamtbelastung haben.

## Revendications

1. Ensemble de blindage de câble (101), comprenant :
un conducteur (107) ; et
un blindage composite conducteur (103) s'étendant autour d'au moins une portion du conducteur, le blindage composite conducteur ayant une matrice non conductrice et des particules conductrices au sein de la matrice non conductrice ;
dans lequel le blindage composite conducteur a une résistivité inférieure à 0,05 ohm.cm ;
**caractérisé en ce que** :
les particules conductrices du blindage composite conducteur ont une concentration en volume au sein de la matrice non conductrice entre 20 % et 40 % de la charge totale.

2. Ensemble de blindage de câble (101) de la revendication 1, comprenant en outre un matériau diélectrique (109) qui s'étend autour d'au moins une portion du conducteur (107), dans lequel le blindage composite conducteur (103) s'étend autour d'au moins une portion du matériau diélectrique.

3. Ensemble de blindage de câble (101) de la revendication 1, comprenant en outre un matériau de gainage (111) qui s'étend autour d'au moins une portion du blindage composite conducteur (103).

4. Ensemble de blindage de câble (101) de la revendication 3, dans lequel le matériau de gainage (111) et le blindage composite conducteur (103) sont au moins partiellement co-extrudés.

5. Ensemble de blindage de câble (101) de la revendication 3, comprenant en outre un fil de masse incorporé et se terminant électriquement entre le blindage composite conducteur (103) et le matériau de gainage (111) et s'étendant à partir de l'ensemble de blindage de câble.

6. Ensemble de blindage de câble (101) de la revendication 1, dans lequel le blindage composite conducteur a une résistivité située entre 0,008 ohm.cm et 0,025 ohm.cm.

7. Ensemble de blindage de câble (101) de la revendication 1, dans lequel le blindage composite conducteur (103) a une épaisseur située entre 0,4 mm et 2 mm, de préférence dans lequel le blindage composite conducteur a une épaisseur située entre 0,1 mm et 0,46 mm.

8. Ensemble de blindage de câble (101) de la revendication 1, dans lequel la matrice non conductrice inclut un matériau sélectionné à partir du groupe consistant en fluorure de polyvinylidène (PVDF), copolymères de fluorure de vinylidène (VDF) et d'hexafluoropropylène (HFP), terpolymères de VDF, de HFP et de tétrafluoro-éthylène (TFE), éthylène propylène fluoré, éthylène tétrafluoro-éthylène, polytétrafluoro-éthylène, une matrice fluorée compatible avec les particules conductrices, polyéthylène, polypropylène, éthylène-vinyle acétate, polyamide, néoprène, et des combinaisons de ceux-ci.

9. Ensemble de blindage de câble (101) de la revendication 1, dans lequel les particules conductrices incluent des particules sélectionnées à partir du groupe consistant en particules de cuivre, particules d'étain, particules de nickel, particules d'aluminium, particules de carbone, noir de carbone, nanotubes de carbone, graphène, particules à placage d'argent, particules à placage de nickel, ou une combinaison de celles-ci.

10. Processus de production d'un ensemble de blindage de câble (101), le processus comprenant :
le positionnement d'un blindage composite conducteur (103), le blindage composite conducteur ayant une matrice non conductrice et des particules conductrices au sein de la matrice non conductrice ;
dans lequel le positionnement a lieu au moins partiellement autour d'un conducteur (107), au moins partiellement autour d'un matériau diélectrique (109), au moins partiellement entouré d'un matériau de gainage (111), ou une combinaison de ceux-ci ;
dans lequel le blindage composite conducteur (103) a une résistivité inférieure à 0,05 ohm.cm ;
**caractérisé en ce que** :
les particules conductrices du blindage composite conducteur ont une concentration en volume au sein de la matrice non conductrice entre 20 % et 40 % de la charge totale.
